# EUROPÄISCHE PATENTSCHRIFT

(11) **EP 1 060 544 B1**
(45) Veröffentlichungstag und Bekanntmachung des Hinweises auf die Patenterteilung: **13.06.2007**
(21) Anmeldenummer: 00904833.1
(22) Anmeldetag: 04.01.2000
(51) Int. Cl.: H01S 5/022

(54) **HALBLEITERCHIP UND VERFAHREN ZUR HERSTELLUNG**
SEMICONDUCTOR CHIP AND METHOD FOR THE PRODUCTION THEREOF
PUCE DE SEMICONDUCTEUR ET SON PROCEDE DE PRODUCTION

(30) Priorität: 04.01.1999 DE 19900052
(43) Veröffentlichungstag der Anmeldung: 20.12.2000
(73) Patentinhaber: Osram Opto Semiconductors GmbH, 93049 Regensburg (DE)
(72) Erfinder: SCHLERETH, Karl-Heinz, D-93133 Burglengenfeld (DE)
(74) Vertreter: Epping - Hermann - Fischer
(86) Internationale Anmeldenummer: PCT/DE2000/000036
(87) Internationale Veröffentlichungsnummer: WO 2000/041280

(56) Entgegenhaltungen:
- FR-A- 2 687 857
- US-A- 5 198 686
- PATENT ABSTRACTS OF JAPAN vol. 008, no. 200 (E-266), 13. September 1984 (1984-09-13) & JP 59 088877 A (HITACHI SEISAKUSHO KK), 22. Mai 1984 (1984-05-22)

## Beschreibung

Die Erfindung bezieht sich auf einen Halbleiterchip mit einer an einem seitlichen Randbereich verlaufenden Bruchflanke, und mit einer an der Bruchflanke endenden elektrisch aktiven Schicht. Die Erfindung betrifft ferner ein Verfahren zur Herstellung eines derartigen Halbleiterchips.

In der Halbleitertechnologie werden Halbeiterchips in Massenfertigung im so genannten Waferverbund hergestellt. Die fertigen einzelnen Halbleiterchips werden dann voneinander getrennt. Dies geschieht durch Sägen oder Anritzen und Brechen entlang der so entstanden Ritzspur. In beiden Fällen können aktive Schichten, die parallel zur Oberfläche des Halbeiterchips verlaufen, an diesen Säge- oder Bruchflanken enden und somit zugänglich sein.

Oft ist es notwendig, einen Halbleiterchip direkt mit einem Leiter zu verlöten. Speziell bei Halbleiterlaserchips (insbesondere bei so genannten Hochleistungs-Laser-Barren) kommt hinzu, dass bei diesen optoelektronischen Bauelementen die aktive Seite (pn-Übergang) nach unten montiert werden muss (p-down-Montage), um eine Spannungsversorgung und/oder eine thermische Wärmeabführung zu realisieren. Die räumliche Nähe der aktiven Schicht des Halbleiterlaserchips zu einer Kontaktfläche ergibt sich hierbei aus der Notwendigkeit, die aktive Schicht zu pumpen und/oder die in der aktiven Schicht entstehende Wärme abzuführen. Die aktive Schicht befindet sich also unmittelbar über der an der unteren Seite angeordneten Kontaktschicht. Wird nun ein solches Bauelement mit einem Leiter verbunden, können Kurzschlüsse durch Lot, das die seitlichen Bruchflanke, und damit die an den Bruchflanke endende aktive Schicht berührt, nicht ausgeschlossen werden, was zum Ausfall des Bauelementes führen kann.

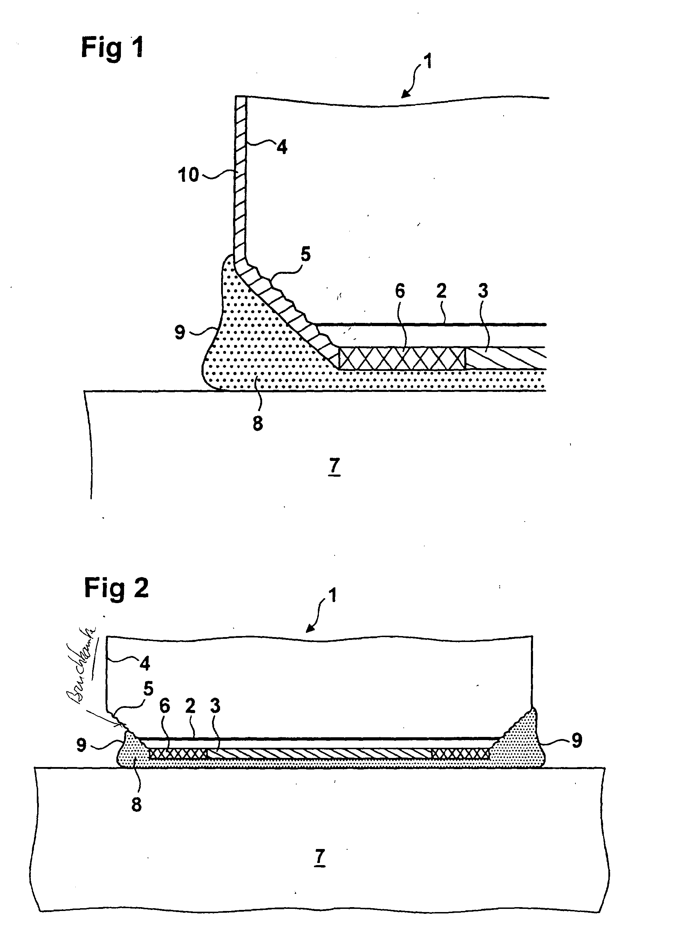

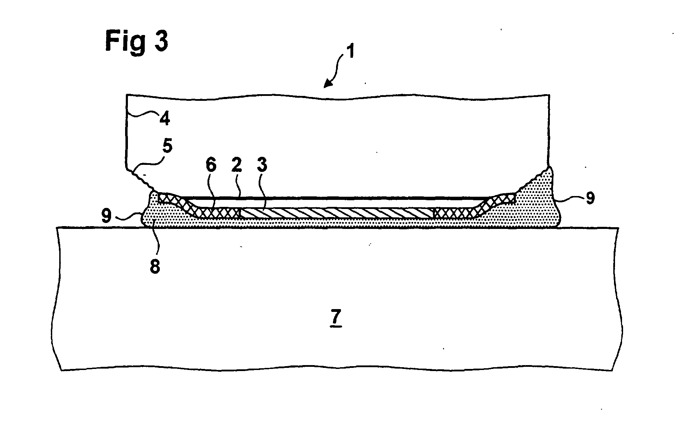

Anhand Figur 2 wird der Aufbau eines bisherigen Halbleiterlaserchips verdeutlicht. Zu sehen ist ein Halbleiterchip 1 mit einer im Halbleitersubstrat ausgebildeten aktiven Schicht 2, der eine Kontaktfläche 3 zugeordnet ist, und die seitlich an der Seite der Bruchflanke 4 endet. Die aktive Schicht 2 tritt an der Bruchflanke 4 innerhalb der in Richtung der Bruchflanke 4 verlaufenden Ritzspur 5 aus. Die Ritzspur 5 wird benötigt um den ursprünglich im Waferverbund befindlichen Halbleiterchip entlang der Bruchflanke 4 zu brechen, und somit vom Waferverbund trennen zu können. Die auf der Unterseite des Halbleiterchips 1 aufgebrachte Kontaktfläche 3 wird durch Isolationsschichtbereiche 6 begrenzt. Der Halbleiterchip 1 wird auf dem flächig ausgebildeten Leiter 7 vermittels eines Lotes 8 verlötet. In der Praxis kommt es dabei häufig vor, dass das Lot 8 an den Bruchflanken des Halbleiterchips oder auch in den Ritzspuren 5, wie in Figur 3 beispielhaft dargestellt, hochsteigt oder einen Wulst 9 bildet. Dadurch kann ein Kurzschluss der aktiven Schicht 2 mit dem Leiter 7 und/oder der Kontaktfläche 3 verursacht, wodurch in Folge ein Defekt der gesamten den eingelöteten Halbleiterchip beinhaltenden elektronischen Schaltung einhergehen kann.

Ein vorbekannter Lösungsansatz für dieses Problem ist in Figur 3 aufgezeigt. Hierbei wird zur Vermeidung eines Kurzschlusses, eine vergleichsweise aufwendige Tiefenätzung im Bereich einer Ritzspur 5 vorgesehen, vermittels welcher etwa 10 µm des Materials des Halbleiterchips abgetragen wird, um eine Überdeckung des Endes der aktiven Schicht 2 durch die nach der Tiefenätzung im Waferverbund aufgebrachten Isolationsschicht 6 zu gewährleisten. Diese Tiefenätzung führt beim Waferprozess zu erheblichen Kosten und Schwierigkeiten, da alle anderen Bereiche der im Waferverbund befindlichen Halbleiterchips überdeckt werden müssen. Schließlich sind auch trotz dieses teuren und aufwendigen Ätzvorgangs bei diesem Typ von Halbleiterchips Kurzschlüsse von aktiven Schichten mit dem Lot beobachtet worden.

Bei einem anderen, aus FR-A-2 687 857 bekannten Halbleiterchip sind geneigte Seitenflächen mittels Ionenimplantation zu halbisolierenden Bereichen umgewandelt. Die Seitenflächen stammen von Vertiefungen, die vor der Ionenimplantation und vor dem Spalten gezielt in den Halbleiterchip beispielsweise mittels eines chemischen Ätzverfahrens eingebracht werden.

Daneben beschreibt die JP(A) 59088877 ein Aufbringen einer isolierenden Schicht auf die Seitenflächen eines Halbleiterkörpers.

Der Erfindung liegt die Aufgabe zu Grunde, einen Halbleiterchip und ein Verfahren zu dessen Herstellung zur Verfügung zu stellen, bei dem auf konstruktiv einfache und daher kostengünstige Weise eine Gefährdung der Halbleiterschaltung durch Kurzschlussbildung ausgeschlossen werden kann.

Diese Aufgabe wird durch einen Halbleiterchip nach Anspruch 1 und ein Verfahren nach Anspruch 7 gelöst.

Erfindungsgemäß ist wenigstens ein dem Ende der aktiven Schicht zugeordneter Abschnitt der Bruchflanke mit einer diesen Abschnitt überdeckenden Passivierung versehen.

Diese Passivierung ist hierbei in einer bevorzugten Ausführung der Erfindung durch eine chemische Umwandlung, insbesondere Oxidation des Ausgangsmaterials der Bruchflanke und auch der an der Bruchflanke endenden aktiven Schicht selbst ausgebildet.

Diese Oxidation wird bevorzugterweise durch einen Ofenprozess im Bereich der an einem seitlichen Randbereiche verlaufenden Bruchflanke durchgeführt. Vorteilhafterweise wird die Oxidation in dem Ofenprozess durch Sauerstoffplasma oder durch Wasserdampf bei erhöhter Temperatur durchgeführt. Von Vorteil hierbei ist, dass in dem Ofenprozess keine wässrige Lösung verwendet wird, daher bleibt die sich einstellende elektrisch isolierende Passivierung aus dem oxidierten Halbleitermaterial im Bereich der Bruchflanke bestehen.

Weitere vorteilhafte Weiterbildungen ergeben sich aus den Unteransprüchen.

Nachfolgend wird die Erfindung anhand mehrerer in der Zeichnung dargestellter Ausführungsbeispiele weiter erläutert. Im Einzelnen zeigen die schematischen Darstellungen in:
- Figur 1: einen schematischen Querschnitt durch einen Halbleiterlaserchip;
- Figur: 2 einen schematischen Querschnitt durch einen vorbekannten Halbleiterlaserchip;
- Figur: 3 einen schematischen Querschnitt durch einen weiteren vorbekannten Halbleiterlaserchip.

In der Figur 1 bezeichnen dieselben Bezugsziffern aus den Figuren 2 und 3 die gleichen oder äquivalenten Bestandteile.

Figur 1 zeigt einen erfindungsgemäßen Halbleiterchip 1, mit einer im Halbleitersubstrat ausgebildeten aktiven Schicht 2-einer Laserschicht-der eine Kontaktfläche 3 zugeordnet ist, und die seitlich an der Seite der Bruchflanke 4 endet und im Bereich der in Richtung der Bruchflanke 4 verlaufenden Ritzspur 5 austritt. Auf der Unterseite des Halbleiterchips 1 ist eine Kontaktfläche 3 aufgebracht, welche durch Isolationsschichtbereiche 6 begrenzt wird, welche aus Si₃N₄, Al₂O₃ oder einem ähnlichem elektrisch isolierenden Material ausgebildet ist. Desweiteren ist eine Passivierung in Form einer Oxidschicht 10 im Bereich des Endes der aktiven Schicht 2 und der Ritzspur 5 zur Abdeckung der sensiblen Bereiche der Seite der Bruchflanke 4 zu sehen. Diese Oxidschicht 10 ist nach dem Zerteilen des Wafers in einzelne Halbleiterchips auf diesen durch eine Oxidation, des beispielsweise im Wesentlichen aus GaAlAs bestehenden Substrats, aufgebracht.

Das im Bereich der Ritzspur 5 beispielsweise zu einem Wulst 9 geformte Lot 8, mit dem der Halbleiterchip 1 auf dem flächig ausgebildeten Leiter 7 verlötet ist, kann somit nicht mehr zu einem Kurzschluss der aktiven Schicht 2 mit dem Leiter 7 und/oder der Kontaktfläche 3 führen.

## Patentansprüche

1. Halbleiterchip mit einer an einem seitlichen Randbereich verlaufenden Bruchflanke (4), und mit einer an der Bruchflanke (4) endenden elektrisch aktiven Schicht (2),
wobei wenigstens ein dem Ende der aktiven Schicht (2)
zugeordneter Abschnitt der Bruchflanke (4) mit einer diesen Abschnitt überdeckenden Passivierung (10) versehen ist **dadurch gekennzeichnet daß** die Passivierung (10) durch eine chemische Umwandlung des Ausgangsmaterials der Bruchflanke (4) und/oder des an der Bruchflanke endenden Bereiches der aktiven Schicht (2) ausgebildet ist.

2. Halbleiterchip nach Anspruch 1,
bei dem die Passivierung (10) durch Oxidation des Ausgangsmaterials der Bruchflanke (4) und/oder des an der Bruchflanke endenden Bereiches der aktiven Schicht (2) ausgebildet ist.

3. Halbleiterchip nach Anspruch 1 oder 2,
bei dem das Grundmaterial des Halbleiterchips Gallium-Aluminium-Arsenid (GaAlAs) aufweist.

4. Halbleiterchip nach einem der Ansprüche 1 bis 3,
bei dem der Halbleiterchip an seinem unteren Bereich eine Kontaktfläche (3) aufweist.

5. Halbleiterchip nach Anspruch 4,
bei dem der Halbleiterchip ein optoelektronisches Bauelement ist, dessen aktive Schicht (2) über die ihr zugeordnete Kontaktfläche (3) durch ein Lot (8) mit einem Leiter (7) verbunden ist.

6. Halbleiterchip nach Anspruch 5,
bei dem das optoelektronische Bauelement ein Laserbauelement, insbesondere ein Leistungs- oder Hochleistungs-Laser-Barren ist.

7. Verfahren zur Herstellung eines Halbleiterchips mit einer an einem seitlichen Randbereich verlaufenden Bruchflanke (4), und mit einer an der Bruchflanke endenden elektrisch aktiven Schicht (2),
bei dem wenigstens ein dem Ende der aktiven Schicht zugeordneter Abschnitt der Bruchflanke mit einer diesen Abschnitt überdeckenden Passivierung (10) versehen wird, wobei der Halbleiterchip in einem Ofenprozess im Bereich der an einem seitlichen Randbereich verlaufenden Bruchflanke (4) wenigstens teilweise passiviert wird.

8. Verfahren nach Anspruch 7, bei dem in dem Ofenprozess durch Sauerstoffplasma oder durch Wasserdampf bei erhöhter Temperatur die zu passivierenden Bereiche des Halbleiterchips, insbesondere das Ausgangsmaterial der Bruchflanke und/oder des an der Bruchflanke (4) endenden Bereiches der aktiven Schicht (2), oxidiert werden.

9. Verfahren nach Anspruch 8, bei dem das Ausgangsmaterial der Bruchflanke und/oder des an der Bruchflanke (4) endenden Bereiches der aktiven Schicht (2) oxidiert werden.

## Claims

1. Semiconductor chip having a fracture flank (4) running at a lateral edge region, and having an electrically active layer (2) ending at the fracture flank (4),
wherein at least one fracture-flank (4) section which is assigned to the end of the active layer (2) is provided with a passivation layer (10) covering said section,
**characterized in that** the passivation layer (10) is formed by chemical conversion of the starting material of the fracture flank (4) and/or of that region of the active layer (2) which ends at the fracture flank.

2. Semiconductor chip according to Claim 1,
in which the passivation layer (10) is formed by oxidation of the starting material of the fracture flank (4) and/or of that region of the active layer (2) which ends at the fracture flank.

3. Semiconductor chip according to Claim 1 or 2,
in which the base material of the semiconductor chip has galliumaluminiumarsenide (GaAlAs).

4. Semiconductor chip according to one of Claims 1 to 3,
in which the semiconductor chip has a contact area (3) on its lower region.

5. Semiconductor chip according to Claim 4,
in which the semiconductor chip is an optoelectronic component whose active layer (2) is connected by a solder (8) to a conductor (7) via the contact area (3) assigned to it.

6. Semiconductor chip according to Claim 5,
in which the optoelectronic component is a laser component, in particular a power laser bar or a high-power laser bar.

7. Method for fabricating a semiconductor chip having a fracture flank (4) running at a lateral edge region, and having an electrically active layer (2) ending at the fracture flank,
in which at least one fracture-flank section which is assigned to the end of the active layer is provided with a passivation layer (10) covering said section,
wherein the semiconductor chip is at least partially passivated in a furnace process in the region of the fracture flank (4) running at a lateral edge region.

8. Method according to Claim 7,
in which in the furnace process, through oxygen plasma or through water vapor at elevated temperature, the regions of the semiconductor chip which are to be passivated, in particular the starting material of the fracture flank and/or of that region of the active layer (2) which ends at the fracture flank (4), are oxidized.

9. Method according to Claim 8,
in which the starting material of the fracture flank and/or of that region of the active layer (2) which ends at the fracture flank (4) are oxidized.

## Revendications

1. Puce semi-conductrice avec un flanc de fracture (4) longeant une zone périphérique latérale, et avec une couche électriquement active (2) se terminant au flanc de fracture (4),
au moins une coupe du flanc de fracture (4), associé à la fin de la couche active (2), étant pourvue d'une passivation (10) recouvrant cette coupe, **caractérisée en ce que** la passivation (10) est formée par une transformation chimique du matériau originel du flanc de fracture (4) et/ou de la zone de la couche active (2) se terminant au flanc de fracture.

2. Puce semi-conductrice selon la revendication 1, pour laquelle la passivation (10) est formée par oxydation du matériau originel du flanc de fracture (4) et/ou de la zone de la couche active (2) se terminant au flanc de fracture.

3. Puce semi-conductrice selon la revendication 1 ou 2, pour laquelle le matériau de base de la puce semi-conductrice présente de l'arséniure de gallium et d'aluminium (GaAlAs).

4. Puce semi-conductrice selon une des revendications 1 à 3, pour laquelle la puce semi-conductrice présente une surface de contact (3) dans sa zone inférieure.

5. Puce semi-conductrice selon la revendication 4, pour laquelle la puce semi-conductrice est un composant optoélectronique dont la couche active (2) est reliée par l'intermédiaire de la surface de contact (3) correspondante, à un conducteur (7) par une soudure (8).

6. Puce semi-conductrice selon la revendication 5, pour laquelle le composant optoélectronique est un composant laser, notamment un barreau laser de puissance ou de haute puissance.

7. Procédé de fabrication d'une puce semi-conductrice avec un flanc de fracture (4) longeant une zone périphérique latérale, et avec une couche électriquement active (2) se terminant au flanc de fracture,
dans lequel au moins une coupe du flanc de fracture associé à la fin de la couche active est pourvue d'une passivation (10) recouvrant cette coupe, la puce semi-conductrice étant passivée au moins partiellement dans un processus de four dans la zone du flanc de fracture (4) longeant une zone périphérique latérale.

8. Procédé selon la revendication 7, dans lequel on oxyde les zones de la puce semi-conductrice à passiver, notamment le matériau originel du flanc de fracture et/ou la zone de la couche active (2) se terminant au flanc de fracture (4), dans le processus de four par plasma d'oxygène ou par vapeur d'eau à une température élevée.

9. Procédé selon la revendication 8, dans lequel on oxyde le matériau originel du flanc de fracture et/ou la zone de la couche active (2) se terminant au flanc de fracture (4).
